(19) Europäisches Patentamt
European Patent Office
Office européen des brevets

(11) **EP 3 449 509 B1**

(12) **EUROPÄISCHE PATENTSCHRIFT**

(45) Veröffentlichungstag und Bekanntmachung des Hinweises auf die Patenterteilung:
**13.05.2020 Patentblatt 2020/20**

(21) Anmeldenummer: **17730042.3**

(22) Anmeldetag: **12.04.2017**

(51) Int Cl.:
***H01L 31/0236*** *(2006.01)*

(86) Internationale Anmeldenummer:
**PCT/DE2017/100299**

(87) Internationale Veröffentlichungsnummer:
**WO 2017/186216 (02.11.2017 Gazette 2017/44)**

(54) **LICHTDURCHLÄSSIGER TRÄGER FÜR EINEN HALBLEITENDEN DÜNNSCHICHTAUFBAU SOWIE VERFAHREN ZUR HERSTELLUNG UND ANWENDUNG DES LICHTDURCHLÄSSIGEN TRÄGERS**

TRANSLUCENT SUPPORT FOR A SEMICONDUCTIVE THIN FILM STRUCTURE, AND METHOD FOR PRODUCING AND USING THE TRANSLUCENT SUPPORT

SUPPORT TRANSPARENT POUR STRUCTURE DE COUCHES MINCES SEMI-CONDUCTRICE AINSI QUE PROCÉDÉ DE PRODUCTION ET UTILISATION DU SUPPORT TRANSPARENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.04.2016 DE 102016107877**

(43) Veröffentlichungstag der Anmeldung:
**06.03.2019 Patentblatt 2019/10**

(73) Patentinhaber: **Helmholtz-Zentrum Berlin für Materialien und Energie GmbH 14109 Berlin (DE)**

(72) Erfinder:
• **BECKER, Christiane 10247 Berlin (DE)**
• **EISENHAUER, David 12157 Berlin (DE)**
• **KÖPPEL, Grit 12435 Berlin (DE)**
• **RECH, Bernd 12587 Berlin (DE)**

(56) Entgegenhaltungen:
DE-A1-102009 006 719    US-A1- 2008 152 868
US-A1- 2009 139 571    US-A1- 2011 132 442
US-A1- 2012 006 399    US-A1- 2012 255 613

EP 3 449 509 B1

**Beschreibung**

Die Erfindung bezieht sich auf einen lichtdurchlässigen Träger für einen halbleitenden Dünnschichtaufbau mit einem Superstrat mit einer für Lichteinfall vorgesehenen Oberseite und einer Unterseite, auf der eine die optischen Eigenschaften des Superstrats verbessernde Lichteinfangstruktur angeordnet ist, an die der Dünnschichtaufbau anschließbar ist, wobei die Lichteinfangstruktur zumindest aus einer dreidimensionalen siliziumoxidhaltigen Strukturschicht auf dem Superstrat und einer an die Strukturschicht anschließenden Antireflexschicht besteht und zusammen mit dem Superstrat eine solche Temperaturstabilität aufweist, dass ein Einsatz für Laserkristallisation zur Erzeugung des Dünnschichtaufbaus möglich ist, sowie auf ein Verfahren zur Herstellung und auf eine Anwendung des lichtdurchlässigen Trägers. Der Begriff Superstrat (super: lat. über und strat von lat. stratum Schicht; darüber liegende Schicht) ist hier synonym verwendet für ein lichtdurchlässiges Substrat in einer sogenannten Superstratkonfiguration, in der eine Solarzelle durch das benannte lichtdurchlässige Substrat beleuchtet wird, letzteres also über der Solarzelle liegt, wie es dem Fachmann bekannt ist. Auf kristallinem Silizium als absorbierendem Halbleiter basierende Dünnschichtsolarzellen haben aufgrund der indirekten Bandlücke und des damit relativ geringen Absorptionskoeffizienten des Siliziums häufig limitierte Kurzschlussströme, die ein Maß für die Leistungsfähigkeit der Solarzelle darstellen. Um die Kurzschlussstromdichte zu erhöhen, werden Lichteinfangstrukturen in die Zelle eingebracht, die eine Entspiegelung bewirken und die Einkopplung des einfallenden Lichts in die Solarzellen verbessern oder die eine Streuung bewirken und die optische Weglänge des Lichts in der Absorberschicht erhöhen. In flüssigphasenkristallisierten Silizium-Dünnschicht-Solarzellen auf Glas wird ohne weitere Maßnahmen an der Grenzfläche von Glas und Silizium bei Beleuchtung durch die Glasseite etwa 20% des Lichtes reflektiert. Das Einbringen von zusätzlichen Schichten an der Glas-Silizium-Grenzfläche ermöglicht eine Verringerung dieser Reflexionsverluste und somit das Erreichen höherer Kurzschlussstromdichten der Solarzellen. Die Verringerung der Reflexionsverluste kann sowohl durch Einbringen flacher als auch dreidimensional nanostrukturierter Schichtsysteme erfolgen, wobei letztere auch einer Erhöhung der Streuung dienen und damit auch über diesen Effekt zu einer Absorptionserhöhung beitragen.

Bei der Festphasenkristallisation wird das amorph abgeschiedene Silizium durch einen einfachen Temperschritt in polykristallines Silizium (mit einigen Mikrometern großen Körnern) umgewandelt. Dabei wird der Aggregatzustand des Siliziums nicht verändert, es verbleibt in der Festphase. Dieser Prozess findet bei relativ niedrigen Temperaturen (ca. 600°C) statt und stellt somit ein kostengünstiges und einfaches Kristallisationsverfahren dar. Die Festphasenkristallisation ist abhängig vom Substrat und startet deshalb mit einer flüssigphasenkristallisierten Keimschicht, auf der dann die Absorberschicht epitaktisch aufgewachsen wird. Bei der Flüssigphasenkristallisation erfolgt eine lokal und zeitlich sehr begrenzte Erhitzung des Siliziums bis oberhalb des Schmelzpunktes (ca. 1.400 °C), sodass über eine Phasenumwandlung eine Neuordnung großer Kristallite eintritt. Hierbei handelt es sich um ein qualitativ sehr hochwertiges Verfahren, bei dem die eingesetzten Materialien aber entsprechend hochtemperaturfest sein müssen.

**Stand der Technik**

Im Falle von flüssigphasenkristallisierten Dünnschichtsolarzellen wurden bislang flache Antireflexschichten oder raue Nanostrukturen zur Entspiegelung verwendet. Flache Antireflexschichten können die Reflexionsverluste an der Glas-Silizium- Grenzfläche verringern, haben aber schlechte optische Eigenschaften. Raue Nanostrukturen ermöglichen eine deutlich bessere Entspiegelung, haben aber negative Auswirkungen auf die elektronischen Eigenschaften der Solarzelle. Flache Lichtstreuer (engl. Flat Light Scattering Substrates, Akronym FLiSS) wurden schon für mikrokristalline Silizium-Solarzellen entwickelt, wobei diese als Rückreflektoren bei Beleuchtung in Substratkonfiguration dienen. Die für die FLiSS-Substrate verwendeten Materialien sind Zinkoxid und n-dotiertes amorphes Silizium. Es wurden sowohl zufällige als auch periodische Strukturen experimentell untersucht, vergleiche beispielsweise die **Veröffentlichung I** (K. Söderström et al.: "Experimental study of flat light-scattering substrates in thin-film silicon solar cells", Solar Energy Materials & Solar Cells 101 (2012) 193-199). Ein Ansatz zum Abflachen von Zufallspyramiden mit einer typischen Periode von 2 $\mu$m und einer typischen Höhe von 800 nm aus glasähnlichem Wasserstoffsilsesquioxan (engl. Hydrogen silsesquioxane, Akronym HSQ) in Superstrat-a-Si-Solarzellen ist in der **Veröffentlichung II** (Y. D. Kim et al.: "Novel patterned layer to enhance conversion efficiency of amorphous silicon thin-film solar cells", Phys. Stat. Solidi A 211 (2014) 1493-1498) beschrieben. Zum Abflachen der Zufallspyramiden wird eine Schleuderbeschichtung von Zinkoxid-Nanopartikeln verwendet. Die zuvor beschriebenen FLiSS-Ansätze eignen sich aber nicht für den Einsatz in laserkristallisierten Silizium-Solarzellen, da die verwendeten Materialien keine ausreichende Temperaturstabilität aufweisen. Die flachen Lichtstreuer zeichnen sich zudem vor allem als streuende Schicht aus und besitzen keine zusätzlichen Eigenschaften als Antireflexschicht. Für die FLiSS-Substrate ergäben sich beim Einsatz in Superstrat-Solarzellen durch das Vorhandensein von amorphem Silizium zudem erhebliche Verluste durch parasitäre Absorption.

Ein weiterer bekannter Ansatz zur Entspiegelung von Grenzflächen ist die Verwendung von mehreren porösen Schichten als Antireflexschichtverbund, vergleiche beispielsweise US 2005/0030629 A1 "Optical Layer System Having Antireflection Properties", US 2011/0151222 A1 "Anti-Reflective Coatings and Methods of making the Same". Dieser Ansatz wird zur Entspiegelung von Luft-Glas-Grenzflächen verwendet und basiert auf der unterschiedlich porösen Aushärtung von zwei siliziumhaltigen Schichten, wobei die eine Schicht als porös und die andere Schicht als glatt bezeichnet werden kann. Die sich ergebende gradiell verlaufende Porosität führt zu einem speziellen Brechungsverhalten zwischen Luft und Glas, wodurch die Reflexion verringert wird. Als Deckschicht wird eine dünne Schicht aus Siliziumoxid verwendet.

Ein solcher poröser Antireflexschichtenverbund ist aber nicht an den Prozess der Entspiegelung einer Glas-Silizium-Grenzfläche anpassbar und auch nicht ausreichend temperaturbeständig für eine Laserkristallisation. Aus der US 2012/0018733 A1 "Thin Films Solar Cells and Other Devices, Systems and Methods of Fabricating Same, and Products Producted by Processes thereof" ist es dagegen bekannt, für eine laserkristallisierte Dünnschicht-Solarzelle an der Grenzschicht zwischen Substrat und Absorber eine Antireflexschicht vorzusehen. Diese kann zweilagig aus Siliziumnitrid und Siliziumoxid aufgebaut sein, ist aber völlig unstrukturiert und somit planar. Der planare Entspiegelungsstandard ist auch aus der **Veröffentlichung III** (D. Armkreutz et al.: "Liquid-Phase Crystallized Silicon Solar Cells on Glass: Increasing the Open-Circuit Voltage by Optimized Interlayers for n- and p-Type Absorbers", IEEE Journal of Photovoltaics, Vol.5, No.6, Nov. 2015, 1757-1761) bekannt. Weiterhin ist es aus der **Veröffentlichung IV** (F. Back et al.: "Periodic nanostructures imprinted on high-temperature stable sol-gel films", Thin Solid Films 563 (2014) 274-281) bekannt, periodische Nanostrukturen mittels Nanoimprint-Lithographie in hochtemperaturstabile Sol-Gel-Schichten auf Glas für Solarzellenanwendungen einzustempeln, die dann durch thermische Behandlung ein Siliziumoxid-Netzwerk bilden.

Flache Antireflexschichten erreichen die nötige hohe elektrische Materialqualität der Siliziumsolarzelle, weisen jedoch nur eingeschränkte optische Eigenschaften auf. Raue Nanostrukturen hingegen ermöglichen gute optische Eigenschaften, allerdings leidet durch die starke Strukturierung der Grenzfläche die Materialqualität des Dünnschichtaufbaus. Somit wird aber das Erreichen einer hohen elektrischen Materialqualität verhindert.

In der **Dissertation** "Laserkristallisierte multikristalline Silicium-Dünnschicht-Solarzellen auf Glas" (Jonathan Plentz, TU Ilmenau, 08.05.2013, urn:nbn:de:gbv:ilm1-2013000305, unter der URL http://www.gbv.de/dms/ilmenau/toc/745828043.PDF, abgerufen am 19.04.2016) offenbart. Für ein Superstrat aus Borosilikatglas für eine Dünnschicht-Solarzelle wird eine die optischen Eigenschaften des Superstrats verbessernde Lichteinfangstruktur an der Grenzfläche Glas-Absorber beschrieben. Superstrat und Lichteinfangstruktur bilden den Träger für den halbleitenden Dünnschichtaufbau. Der Dünnschichtabsorber wird mittels schichtweiser Laserkristallisation mit Festphasenumwandlung (s. Kap. 1.3.3) bei Prozesstemperaturen von 600°C epitaktisch auf einer Keimschicht aufgezogen. Die Keimschicht wurde zuvor mittels laserunterstützter Flüssigphasenumwandlung bei lokal 1414 °C (s. Kap. 1.3.2., Seite 25, erster Absatz) auf die Lichteinfangstruktur aufgebracht. Diese weist entsprechend eine solche Temperaturstabilität auf, dass ein Einsatz für Festphasen-Laserkristallisation zur Erzeugung des Dünnschichtaufbaus möglich ist. In diesem Zusammenhang (s. Kap. 4.1.2, S. 56 unten) wird in der Veröffentlichung aber darauf hingewiesen, dass bereits während der erforderlichen Flüssigphasenkristallisation bei der Erzeugung der extrem dünnen Keimschicht die Glastextur eingeebnet und flacher wird. Dies soll aber verhindert werden. Es werden daher strukturerhaltende Maßnahmen durch Verringerung der Laserleistung ergriffen, was sich aber nachteilig auch auf die nachfolgende Festphasenepitaxie des Dünnschichtaufbaus auswirken kann. Mit der bekannten Lichteinfangstruktur ist daher nur ein Dünnschichtaufbau mittels Festphasenepitaxie möglich.

Die bekannte Lichteinfangstruktur ist zweischichtig aufgebaut und besteht aus einer dreidimensionalen siliziumoxidhaltigen Strukturschicht auf dem Superstrat und einer an die Strukturschicht anschließenden Antireflexschicht. Die siliziumoxidhaltige Strukturschicht ist inhomogen und besteht aus 500 nm großen Quartzkugeln, die aus einem Sol-Gel-Bad durch Temperung aufgebracht wurden (s. Kap. 2.1.2, Seite 32, zweiter Absatz). Auf die entstandene unperiodische Zufallsstruktur wird dann eine flache Antireflexschicht aus Siliziumnitrid (80 nm, Brechungsindex 1,9...2,1) oder Tantalpentoxid (Brechungsindex 2,0...2,2) abgeschieden (s. Kap. 4.2.3). Dabei verändert die Antireflexschicht aber nicht die Oberfläche der Strukturschicht. Anschließend wird eine Keimschicht als Start für den festphasenkristallisierten Dünnschichtaufbau aufgebracht.

In der US 2011 / 0 132 442 A1 wird eine Lichteinfangstruktur offenbart, in der die Wirksamkeit erhöht ist durch Nanostrukturierung in Form von Graten einer ersten Oxidschicht auf einem Substrat, auf die eine zweite Oxidschicht aufgebracht wird, die die Rauigkeit der ersten Schicht abmildert. Dadurch wird zum einen eine gute Transmission gewährleistet und zugleich eine Verbesserung der elektronischen Eigenschaften in Hinblick auf Rekombinationen. Das Substrat ist hier vorgesehen zur Verwendung als Superstrat.

Eine Lichteinfangstruktur wird ebenfalls in der DE 10 2009 006 719 A1 offenbart, die den nächstliegenden Stand der Technik bildet. Diese Lichteinfangstruktur weist ein transparentes Substrat auf, das eine strukturierte Schicht mit einem periodischen Muster aufweist. Die strukturierte Schicht wird durch Prägen oder Drucken einer Schicht gebildet, die nach dem Sol-Gel-Verfahren hergestellt ist. Der Abstand zwischen den Erhöhungen und/oder Vertiefungen benachbarter periodischer Muster der strukturierten Schicht liegt dabei im Submikrometer-Bereich. Das Substrat ist auch hier vorgesehen zur Verwendung als Superstrat in einer Solarzelle in Supertratkonfiguration.

## Aufgabenstellung

Die **Aufgabe** für die vorliegende Erfindung besteht darin, den zuvor beschriebenen gattungsgemäßen Träger aus einem Superstrat und einer Lichteinfangstruktur, der für einen laserkristallisierten Dünnschichtaufbau geeignet ist, hinsichtlich seiner die optischen Eigenschaften des Superstrats verbessernden Eigenschaften noch weiter zu optimieren, wobei auch die elektronischen Eigenschaften der Lichteinfangstruktur optimiert werden sollen. Dabei muss daher gewährleistet sein, dass durch die Strukturierung der Grenzfläche zwischen Superstrat und Dünnschichtabsorber dessen Materialqualität nicht leidet. Weiterhin muss insbesondere für die Lichteinfangstruktur die Eignung für die einer nachfolgenden Prozesskette verwendeten Technologien, wie die Flüssigphasenkristallisation mit hohen lokalen Prozesstemperaturen, gewährleistet sein. Die **Lösung** für diese Aufgabe ist dem Hauptanspruch zu entnehmen. Vorteilhafte Modifikationen werden in den Unteransprüchen aufgezeigt, die nachfolgend im Zusammenhang mit der Erfindung näher erläutert werden. Des Weiteren werden ein besonders bevorzugtes Herstellungsverfahren für den beanspruchten Träger sowie eine für ihn besonders bevorzugte Anwendung aufgezeigt.

Bei dem beanspruchten Träger ist erfindungsgemäß vorgesehen, dass die dreidimensionale Strukturschicht als homogene Siliziumoxidschicht mit einer periodischen Nanostruktur mit einer Periode zwischen 200 nm und 1000 nm und eine erste Antireflexschicht als nanokristalline Titanoxidschicht oder als Zinnoxidschicht ausgebildet sind. Dabei verringert die erste Antireflexschicht die Höhe der Nanostruktur der Strukturschicht erfindungsgemäß um mindestens 30 %. Eine deutliche Abflachung der Nanostruktur auf maximal 70 % ihrer ursprünglichen Höhe ist die Folge. Dabei sind ohne Weiteres aber auch stärkere Abflachungen möglich. Um eine wirkungsvolle Glättung der Nanostruktur zu erhalten, ist die relative Abflachung umso größer, je höher die Nanostruktur ist. Erfindungsgemäß beträgt die Höhe der Lichteinfangstruktur zwischen 20 nm und 200 nm und die Winkel zwischen den Oberflächen der Lichteinfangstruktur und der Unterseite des Superstrats sind nicht größer als 60°. Schließlich ist erfindungsgemäß auf der Lichteinfangstruktur noch eine Passivierungsschicht angeordnet. Dabei ist erfindungsgemäß eine Temperaturstabilität des Trägers für eine Flüssigphasenkristallisation gegeben.

Mit der Erfindung wird eine glatte und zugleich dreidimensional texturierte Lichteinfangstruktur für die innere Grenzfläche zwischen dem transparenten Superstrat und einem Dünnschichtaufbau zur Verfügung gestellt. Zutreffend kann die erfindungsgemäße Lichteinfangstruktur mit dem Akronym "SMART-Textur" (Akronym SMooth Anti Reflective Three-dimensional) bezeichnet werden. Durch die Verwendung einer solchen dreidimensional texturierten, aber trotzdem an der Oberfläche glatten Lichteinfangstruktur wird eine zu flachen Antireflexschichten äquivalente Materialqualität erreicht, wohingegen die Entspiegelungseigenschaften mit denen von rauen Nanostrukturen vergleichbar sind. Es werden in der Lichteinfangstruktur des erfindungsgemäßen Trägers die vorteilhaften Eigenschaften von flachen Antireflexschichten (Verringerung der Reflexionsverluste an der Grenzfläche, hohe elektrische Materialqualität) und rauen Nanostrukturen (sehr gute optische Eigenschaften, sehr gute Entspiegelung durch hohe Lichtstreuung) in optimaler Weise miteinander kombiniert. Durch das Kombinieren der vorteilhaften Eigenschaften auf hohem Niveau kann mit dem erfindungsgemäßen Träger als Superstrat in prozessierten Dünnschicht-Solarzellen eine deutliche Vergrößerung der Kurzschlussstromdichte und damit eine deutliche Erhöhung der Solarzellenleistung erreicht werden. Dabei werden erfindungsgemäß für die beanspruchte Lichteinfangstruktur nur Materialien mit einer solchen Temperaturstabilität eingesetzt, dass der anschließende Dünnschichtaufbau auch mittels Flüssigphasenkristallisation (mit lokalen und temporären Prozesstemperaturen von ca. 1.400°C) erfolgen kann. Eine kurzzeitige Temperaturfestigkeit bis 950°C ist dafür ausreichend.

Die Lichteinfangstruktur des mit der Erfindung beanspruchten Trägers weist eine spezielle Kombination aus konstruktiven und materiellen Parametern auf. Gegenüber der aus dem nächstliegenden Stand der Technik bekannten inhomogenen und unperiodischen Zufallsstrukturschicht ist die erfindungsgemäße Strukturschicht homogen, periodisch und kein Zufallsprodukt. Sie ist damit in gleichbleibend hoher Qualität zuverlässig reproduzierbar. Ihre optischen Eigenschaften, die durch eine spezielle geometrische Struktur und nicht durch eine inhomogene Schichtung von Kugeln und Zwischenräumen erzeugt werden, sind genau vorhersehbar und einstellbar. Das verwendete Siliziumoxid ist im erforderlichen Maße temperaturbeständig.

Die raue Nanostruktur könnte sich aber nachteilig auf den zu prozessierenden Dünnschichtaufbau auswirken. Deshalb wird bei der Erfindung die raue Strukturschicht durch das Aufbringen der ersten Antireflexschicht in ihren Abmessungen zum zu prozessierenden Dünnschichtaufbau hin abgemildert bzw. vergleichmäßigt bzw. geglättet. Dabei wird durch das Aufbringen der ersten Antireflexschicht die relative Höhe der Nanostruktur der Strukturschicht um mindestens 30 % verringert. Es ergibt sich eine gewellte, gegenüber der rauen Strukturschicht durchaus als "glatt" zu bezeichnende Oberfläche. Die Auswirkungen einer derart vergleichmäßigten, geglätteten Strukturschicht auf den nachfolgend zu prozessierenden Dünnschichtaufbau sind deutlich geringer als bei sehr rauen Strukturschichten. Durch das Abflachen werden durch die Nanostruktur der Strukturschicht in einer mittels Flüssigphasenkristallisation zu prozessierenden Dünnschicht möglicherweise verursachten Defekte (Entnetzungen, Risse, Versetzungen) minimiert. Es können qualitativ sehr hochwertige Dünnschichten prozessiert werden. Dies gilt insbesondere für die Flüssigphasenkristallisation, die - im Gegensatz zur Festphasenkristallisation - ohne Keimschicht direkt auf dem strukturierten Superstrat prozessiert wird.

Insgesamt weist die beanspruchte Lichteinfangstruktur eine Höhe zwischen 20 nm und 200 nm auf. Dabei entspricht die Höhe aufgrund der glatten Oberfläche in etwa der mittleren Höhe der schwach gewellten Struktur. Zudem sind die Winkel zwischen den Oberflächen der Lichteinfangstruktur in Richtung auf den zu prozessierenden Dünnschichtaufbau und der Unterseite des Superstrats stets nicht größer als 60°. Dadurch ergeben sich optimale lichtstreuende Eigenschaften der Oberfläche der Lichteinfangstruktur. Dadurch, dass sowohl die Lichtreflexion minimiert als auch die Lichtstreuung maximiert ist, ist die Lichteinfangstruktur optimiert und trägt zur deutlichen Erhöhung der Kurzschlussströme und damit zum Wirkungsgrad des zu prozessierenden Dünnschichtaufbaus bei. Weitere Details zu dem mit der vorliegenden Erfindung beanspruchten Träger und zu vorteilhaften Modifikationen davon sind den Ausführungsbeispielen zu entnehmen.

Desweiteren wird ein bevorzugtes und vorteilhaftes Verfahren zur Herstellung des Trägers nach der Erfindung beansprucht, das zumindest folgende Verfahrensschritte umfasst:

- Bereitstellen eines lichtdurchlässigen Superstrats,
- Aufbringen einer siliziumbasierten Sol-Gel-Schicht auf die Unterseite des Superstrats,
- Einstempeln einer periodischen Nanostruktur in die Sol-Gel-Schicht mittels Nanoimprint-Lithographie,
- thermische Behandlung der strukturierten Sol-Gel-Schicht zur Ausbildung einer strukturierten Siliziumoxidschicht als Strukturschicht auf dem Superstrat,
- Aufbringen einer Titanoxid- oder Zinnoxid-Vorläuferlösung auf die Strukturschicht mittels Schleuderbeschichtung,
- thermische Behandlung der aufgeschleuderten Titanoxid- oder Zinnoxid-Vorläuferlösung zur Ausbildung einer nanokristallinen Titanoxidschicht oder Zinnoxidschicht als erste Antireflexschicht und
- Aufbringen von Siliziumoxid oder Siliziumoxinitrid auf die ausgebildete erste Antireflexschicht durch physikalische oder chemische Gasphasenabscheidung zur Ausbildung einer Passivierungsschicht auf der ersten Antireflexschicht,

wobei alle verwendeten Komponenten eine Temperaturstabilität dauerhaft bis 650°C und kurzzeitig bis 950°C aufweisen.

Bevorzugt und vorteilhaft wird bei dem beanspruchten Verfahren noch ein zusätzlicher Verfahrensschritt mit einem Aufbringen einer zweiten Antireflexschicht im Anschluss an das Aufbringen der ersten Antireflexschicht, wobei die zweite Antireflexschicht einen Brechungsindex aufweist, der größer ist als der effektive Brechungsindex der gesamten Lichteinfangstruktur, und wobei die Passivierungsschicht dann auf die zweite Antireflexschicht aufgebracht wird, eingefügt. Die zweite Reflexschicht führt zur weiteren Glättung der Nanostruktur der Strukturschicht und damit zu einer weiteren Güteverbesserung der anschließend zu prozessierenden Halbleiter-Dünnschicht. Bei der zweiten Antireflexschicht kann es sich bevorzugt um Siliziumnitrid handeln.

Alle in der Herstellung verwendeten Prozesse sind einfach, großflächig und günstig und somit industriell relevant. Dabei werden erfindungsgemäß für die beanspruchte Lichteinfangstruktur nur Materialien mit einer solchen Temperaturstabilität eingesetzt, dass der anschließende Dünnschichtaufbau auch mittels Flüssigphasenkristallisation (mit lokalen und temporären Prozesstemperaturen von ca. 1400°C) erfolgen kann, insbesondere ist eine kurzzeitige Temperaturstabilität bis 950°C ausreichend. Eine besondere Anwendung des Trägers nach der Erfindung wird daher beansprucht, bei der es sich um einen Prozess zur Erzeugung eines halbleitenden Dünnschichtaufbaus zur Verwendung in einer Solarzelle handelt, wobei der halbleitende Dünnschichtaufbau durch Flüssigphasen-Laserkristallisation erzeugt wird. Die hierbei kurzzeitig lokal auftretenden sehr hohen Prozesstemperaturen können von dem beanspruchten Träger aufgrund seines speziellen Aufbaus und seiner speziellen Materialwahl ohne Beschädigungen oder Beeinträchtigungen ausgehalten werden.

**Ausführungsbeispiele**

Ausführungsbeispiele des lichtdurchlässigen Trägers nach der Erfindung werden nachfolgend zu dessen weiterem Verständnis anhand einzelner schematischer, nicht maßstabsgetreuer Figuren näher erläutert. Dabei zeigt die

**Figur 1** ein Schema zur Erzeugung des Trägers mit einer detaillierten Darstellung des Trägers,
**Figur 2** eine mit dem Träger prozessierte Solarzelle mit einem Diagramm zum Leistungsvergleich und
**Figur 3** eine mikroskopische Aufnahme (SEM) eines geglätteten Trägers.

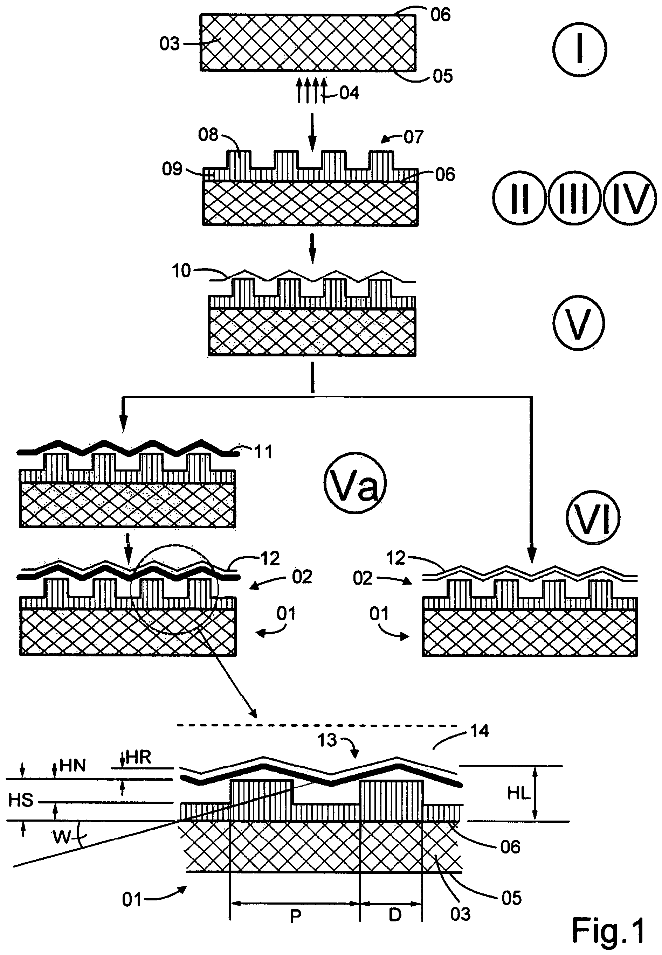

In der **Figur 1** ist in einem Verfahrensschritt **I** ein lichtdurchlässiges, transparentes Superstrat **03**, das bevorzugt aus Glas, beispielsweise aus Borosilikatglas, besteht und bevorzugt großflächig ausgebildet ist, bereitgestellt. Das Superstrat **03** weist eine Oberseite **05** und eine Unterseite **06** auf. Die Oberseite **05** ist im späteren Einsatzfall dem Lichteinfall **04** ausgesetzt, auf die Unterseite **06** wird eine Lichteinfangstruktur **02** aufgebracht, auf der anschließend ein funktionaler Dünnschichtaufbau **14** einer Solarzelle prozessiert werden kann. Erfindungsgemäß ist der Träger **01**, bestehend aus dem Superstrat **03**, der Lichteinfangstruktur **02** und einer Passivierungsschicht **12**, temperaturstabil auch für eine Flüssigphasenkristallisation des Dünnschichtaufbaus **14**. Bevorzugt und vorteilhaft ist es deshalb, wenn die Temperaturstabilität dauerhaft bis zu einer Temperatur von 650°C und kurzzeitig bis zu einer Temperatur von 950°C gewährleistet ist. Dabei bezieht sich der Begriff "dauerhaft" auf die gesamte Prozessierungszeit für den Dünnschichtaufbau und der Begriff "kurzzeitig" auf eine Flüssigphasenprozessierung im Bereich von einigen Millisekunden.

In Verfahrensschritten **II, III** wird zunächst eine siliziumbasierte hochtemperaturstabile Sol-Gel-Schicht auf die Unterseite **06** des Superstrats **03** aufgebracht und anschließend mittels Nanoimprint-Lithographie strukturiert. Wesentliche Faktoren für die vorteilhafte Strukturschicht **09** bei der beanspruchten Lichteinfangstruktur **02** sind die Homogenität und die Periodizität der Nanostruktur der Strukturschicht. Besonders vorteilhaft und bevorzugt ist es dabei, wenn die periodische Nanostruktur **07** in Form von zueinander beabstandeten Nanozylindern **08** ausgebildet ist und das sich in Abhängigkeit von Durchmesser **D**, Periode **P** und Anordnung der Nanozylinder ergebende Füllverhältnis zwischen dem Siliziumoxid für die Strukturschicht **09** und dem Titanoxid oder Zinnoxid für die erste Antireflexschicht **10** zwischen 0,2 und 0,5 liegt.

In der **Figur 1** ist eine Nanostruktur **07** in Form von zueinander beabstandeten Nanozylindern **08** dargestellt. Die Nanozylinder **08** weisen einen Durchmesser **D**, eine Höhe **HN** und eine Periode **P** auf (siehe Detaildarstellung). Gewählt ist eine hexagonale Anordnung. Bei dieser Nanostruktur **07** ergibt sich ein Füllverhältnis gemäß $\pi\, r^2 / \sqrt{3}\ p^2$. Besonders bevorzugt und vorteilhaft ist eine Parametrierung, bei der die Periode **P** der periodischen Nanostruktur **07** 750 nm bei einer hexagonalen Anordnung der Nanozylinder **08**, die Höhe **HL** der Lichteinfangstruktur **02** 60 nm und das Füllverhältnis 0,25 betragen. Die Parameter der Lichteinfangstruktur **02** sind in der Detaildarstellung aufgezeigt.

Alternativ zu der zylindrischen Ausprägung der homogenen Nanostruktur **07** kann diese auch jede andere Art der periodischen Ausprägung annehmen. Vorteilhaft und bevorzugt ist es, wenn die periodische Nanostruktur **07** eine nicht-zylindrische Ausprägung aufweist und das sich als Quotient aus einem Äquivalenzdurchmesser der nicht-zylindrischen Ausprägungen zur Periode P der nicht-zylindrischen Ausprägungen ergebende Füllverhältnis zwischen dem Siliziumoxid für die Strukturschicht **09** und dem Titanoxid oder Zinnoxid für die erste Antireflexschicht **10** zwischen 0,2 und 0,5 liegt. Beispielsweise kann bei einer kegeligen Ausprägung der Nanostruktur **07** der auf einfachen geometrischen Berechnungen beruhende Äquivalenzdurchmesser beispielsweise die Breite bei halber Höhe der Nanostruktur **07** betragen.

In einem Verfahrensschritt **IV** wird dann eine thermische Behandlung der strukturierten Sol-Gel-Schicht durchgeführt, sodass eine strukturierte Siliziumoxidschicht (Siliziumoxid-Netzwerk) als Strukturschicht **09** auf dem Superstrat **03** entsteht.

In einem Verfahrensschritt **V** wird die Strukturschicht **09** dann geglättet bzw. abgeflacht. Dazu wird eine erste Antireflexschicht **10** aufgebracht. Dies erfolgt durch Aufbringen einer Titanoxid- oder Zinnoxid-Vorläuferlösung auf die Strukturschicht **09** mittels Schleuderbeschichtung und anschließende thermische Behandlung der aufgeschleuderten Titanoxid- oder Zinnoxid-Vorläuferlösung zur Ausbildung einer nanokristallinen Titanoxidschicht oder Zinnoxidschicht als erste Antireflexschicht **10**.

In einem zusätzlichen Verfahrensschritt **Va** kann dann noch bevorzugt und vorteilhaft eine zweite Antireflexschicht **11**, beispielsweise aus Siliziumnitrid, auf die erste Antireflexschicht **10** aufgebracht werden. Die zweite Antireflexschicht **11** ist weiterer Bestandteil der Lichteinfangstruktur **02** und weist einen Brechungsindex auf, der größer ist, als der effektive Brechungsindex der gesamten Lichteinfangstruktur **02** ist. Durch die zweite Antireflexschicht **11** wird der reflektierte Lichtanteil an der Grenzschicht zwischen Superstrat **03** und zu prozessierendem Dünnschichtaufbau **14** noch weiter verringert und damit die Absorption noch weiter erhöht.

In einem abschließenden Verfahrensschritt **VI** wird dann eine Passivierungsschicht **12** entweder auf die erste Antireflexschicht **10** oder auf die zweite Antireflexschicht **11** aufgebracht. Die Passivierungsschicht **12** kann durch Aufbringen von bevorzugt und vorteilhaft Siliziumoxid oder Siliziumoxinitrid durch physikalische oder chemische Gasphasenabscheidung ausgebildet werden. Im Verfahrensschritt **VI** ist dann der fertigprozessierte Träger **01** mit einer (rechts) oder zwei (links) Antireflexschichten **10**, **11** dargestellt.

In der Detaildarstellung werden die geometrischen Parameter der beanspruchten Lichteinfangstruktur **02** erläutert. Dargestellt ist die gesamte Höhe **HL** der Lichteinfangstruktur **02**. Aufgrund der glatten Oberfläche entspricht die gezeigte Höhe **HL** der gemittelten Höhe der Lichteinfangstruktur **02**. Die Höhe **HL** der Lichteinfangstruktur **02** liegt im Bereich von 20 nm bis 200 nm, bevorzugt beispielsweise 60 nm. Die Höhe der Strukturschicht **09** ist mit HS bezeichnet. Gezeigt ist auch die geglättete Resthöhe **HR** der Lichteinfangstruktur **02**, die sich nach dem Aufbringen der ersten und ggfs. der zweiten Antireflexschicht **10**, **11** ergibt. Die Höhe **HN** der Nanostruktur **07** wird um mindestens 30 % verringert. Die Periode **P** der gezeigten Nanostruktur **07** liegt zwischen 200 nm und 1000 nm, bevorzugt 350 nm oder 750 nm. Zwischen den Oberflächen **13** der Lichteinfangstruktur **02** und der Unterseite **06** des Superstrats **03** liegen Winkel **W**, die nicht größer als 60° sind. Angedeutet ist auch der anschließend zu prozessierende Dünnschichtaufbau **14**.

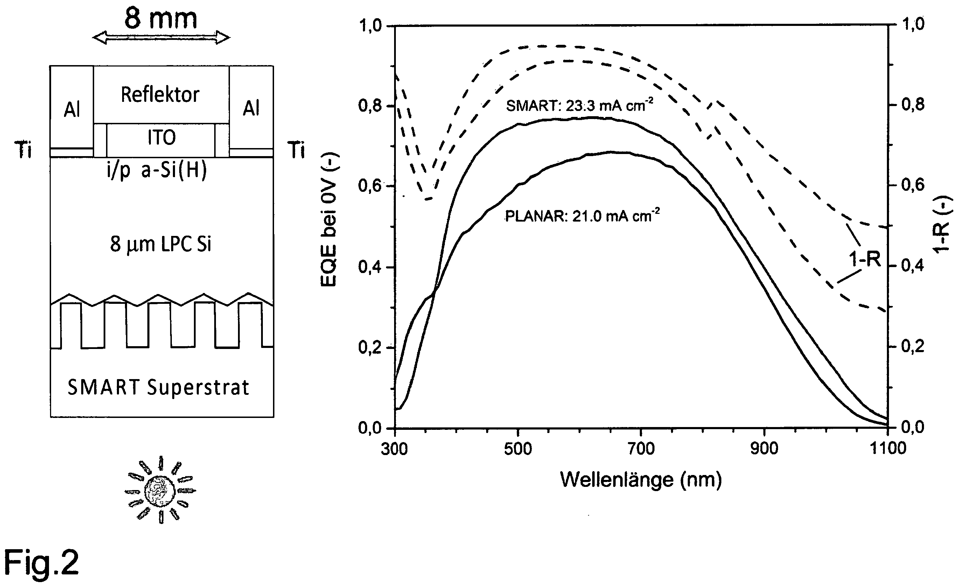

In der **Figur 2** ist links schematisch eine mit dem Träger **01** und der Lichteinfangstruktur **02** prozessierte Solarzelle (SMART) in einem schematischen Querschnittsausschnitt dargestellt, die prozessiert und in ihren Parameterwerten überprüft wurde. Es handelt sich um eine rückseitenkontaktierte Solarzelle mit Kontakten Al und einer Kontaktfläche Ti, einem rückstreuenden Rückseitenreflektor hinter einem leitfähigen Fenster ITO zwischen den Kontakten Al, und einem halbleitenden Dünnschichtaufbau 14 aus einem intrinsischen Schicht und einem wasserstoffgesättigten amorphen Emitter i/p a-Si(H) sowie einem flüssigphasenkristallisierten Absorber (8 $\mu$m LPC Si). Diese Solarzelle wurde auch mit einem planaren Substrat (d.h. nur mit einer Antireflexschicht ohne eine Nanostrukturierung, bestehend aus 70 nm SiNx und 10nm SiOx, in Übereinstimmung mit z.B. US2012/0018733 A1) prozessiert (PLANAR). Es ergibt sich folgender Parametervergleich (Leerlaufspannung $V_{oc}$, Kurzschlussstromdichte $J_{sc}$, Füllfaktor FF, möglicher Wirkungsgrad $\eta$, Wertedifferenz):

| Parameter \ Typ | PLANAR | SMART | $\Delta$ % |
|---|---|---|---|
| max. $V_{oc}$ (mV) | 636 | 649 | + 2 % |
| max $J_{sc}$ (mA/cm$^2$) | 21,0 | 23,3 | **+ 11 %** |
| max, pseudo FF (%) | 81,0 | 79,3 | -2 % |
| $\eta$ potential (%) | 10,8 | 12,0 | +11 % |

Zu erkennen ist, dass mit einer Solarzelle, die auf dem mit der Erfindung beanspruchten Träger **01** mit der SMART-Licheinfangstruktur prozessiert ist, gegenüber einer PLANAR-Lichteinfangstruktur eine deutliche Verringerung der Reflexion an der Glas-Silizium-Grenzfläche erreicht wird. Dies führt durch die gleichzeitige sehr gute Materialqualität zu einer Erhöhung der Kurzschlussstromdichte und damit des möglichen Wirkungsgrades der prozessierten Solarzelle erzielt werden kann.

Dies ist auch in dem rechten Diagramm (EQE (Akronym External Quantum Efficiency) bei 0V Vorspannung und Einkopplung 1-R über der eingestrahlten Wellenlänge in nm) in der **Figur 2** zu erkennen. R ist die Reflexion der kompletten Solarzelle wie im Schema links gezeigt, das heißt unter 1-R wird der Anteil des Lichtes verstanden, der in den Absorber eingekoppelt wird. Der Bereich zwischen 1-R und EQE stellt die Einstrahlungsverluste dar. Durch den Kurvenverlauf von 1-R wird besonders deutlich, dass die optischen Eigenschaften durch die Einführung der SMART-Textur im Vergleich zur PLANAR-Textur bedeutsam verbessert werden. Diese erhöhte Einkopplung führt dann - bei gleichbleibender Materialqualität unter der Strukturierung - zu einer besseren externen Quanteneffizienz, welche direkt für den Kurzschlussstrom der Solarzelle verantwortlich ist.

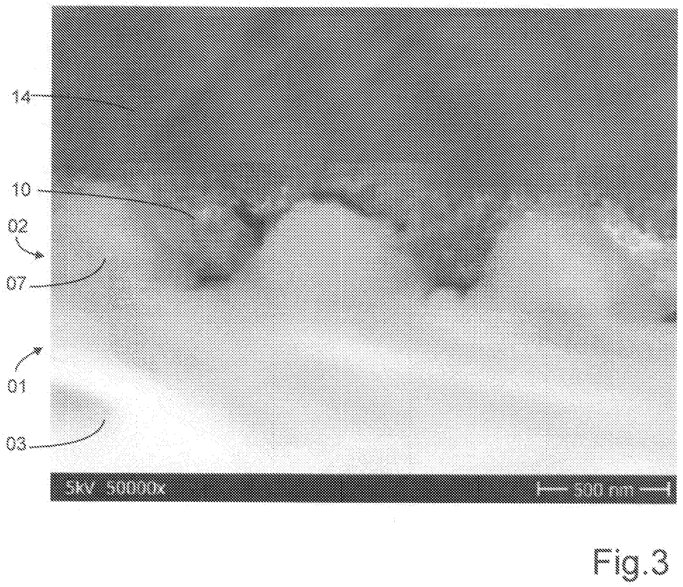

In der **Figur 3** ist noch eine mikroskopische Aufnahme (SEM) eines präparierten Trägern **01** dargestellt. Deutlich ist die sehr starke Glättung der Nanostruktur **07** durch die darüber liegende Antireflexschicht **10** zu erkennen.

Mit dem zuvor beschriebenen Träger **01** nach der Erfindung wird eine glatte und zugleich dreidimensional texturierte Lichteinfangstruktur **02** (SMART-Textur) für die innere Grenzfläche zwischen dem transparenten Superstrat **03** und einem Dünnschichtaufbau **14**, der bevorzugt mittels Flüssigphasenkristallisation hergestellt werden kann, zur Verfügung gestellt, der Einstrahlungsverluste durch eine Verringerung von Reflexionsverlusten und durch eine Absorptionssteigerung durch eine Vergrößerung der Streuung bewirkt. Es ergibt sich eine deutliche Vergrößerung der Kurzschlussstromdichte und damit eine deutliche Verbesserung der Solarzelleneffizienz.

Bezugszeichenliste

01   lichtdurchlässiger Träger
02   Lichteinfangstruktur
03   Superstrat
04   Lichteinfall
05   Oberseite von 03
06   Unterseite von 03
07   Nanostruktur
08   Nanozylinder
09   Strukturschicht
10   erste Antireflexschicht
11   zweite Antireflexschicht
12   Passivierungsschicht
13   Oberfläche von 02
14   halbleitender Dünnschichtaufbau

HL      Höhe der Lichteinfangstruktur
HN      Höhe der Nanostruktur
HS      Höhe der Strukturschicht
HR      Resthöhe HL - HS
P       Periode der Nanostruktur
D       Durchmesser der Nanozylinder

**Patentansprüche**

1.  Lichtdurchlässiger Träger (01) für einen halbleitenden Dünnschichtaufbau (14) mit einem Superstrat (03) mit einer für Lichteinfall (04) vorgesehenen Oberseite (05) und einer Unterseite (06), auf der eine die optischen Eigenschaften des Superstrats (03) verbessernde Lichteinfangstruktur (02) angeordnet ist, an die der Dünnschichtaufbau (14) anschließbar ist, wobei die Lichteinfangstruktur (02) zumindest aus einer dreidimensionalen Strukturschicht (09) im Submikrometerbereich aus Siliziumoxid auf dem Superstrat (03) besteht,
    **dadurch gekennzeichnet, dass**
    die dreidimensionale Strukturschicht (09) mit einer periodischen Nanostruktur (07) mit einer Periode P zwischen 200 nm und 1000 nm und eine auf die Strukturschicht (09) folgende erste Antireflexschicht (10) als nanokristalline Titanoxidschicht oder als Zinnoxidschicht ausgebildet sind, wobei die erste Antireflexschicht (10) die relative Höhe HN der Nanostruktur (07) der Strukturschicht (09) um mindestens 30% verringert, so dass die Resthöhe HR der Lichteinfangstruktur (02) geglättet ist, und wobei die Höhe HL der Lichteinfangstruktur (02) zwischen 20 nm und 200 nm beträgt und die Winkel W zwischen den Oberflächen (13) der Lichteinfangstruktur (02) und der Unterseite (06) des Superstrats (03) nicht größer als 60° sind, und dass auf der Lichteinfangstruktur (02) eine Passivierungsschicht (12) angeordnet ist, wobei eine Temperaturstabilität des Trägers (01) für eine Flüssigphasenkristallisation gegeben ist.

2.  Lichtdurchlässiger Träger (01) nach Anspruch 1,
    **dadurch gekennzeichnet, dass**
    die periodische Nanostruktur (07) in Form von zueinander beabstandeten Nanozylindern (08) ausgebildet ist und das sich in Abhängigkeit von Durchmesser D, Periode P und Anordnung der Nanozylinder (08) ergebende Füllverhältnis zwischen dem Siliziumoxid für die Strukturschicht (09) und dem Titanoxid oder Zinnoxid für die erste Antireflexschicht (10) zwischen 0,2 und 0,5 liegt.

3.  Lichtdurchlässiger Träger (01) nach Anspruch 2,
    **dadurch gekennzeichnet, dass**
    die Periode P der periodischen Nanostruktur (07) 750 nm bei einer hexagonalen Anordnung der Nanozylinder (08), die Höhe HL der Lichteinfangstruktur (02) 60 nm und das Füllverhältnis 0,25 beträgt.

4.  Lichtdurchlässiger Träger (01) nach Anspruch 1,
    **dadurch gekennzeichnet, dass**
    die periodische Nanostruktur (07) eine nicht-zylindrische Ausprägung aufweist und das sich als Quotient aus einem Äquivalenzdurchmesser der nicht-zylindrischen Ausprägungen zur Periode P der nicht-zylindrischen Ausprägungen ergebende Füllverhältnis zwischen dem Siliziumoxid für die Strukturschicht (09) und dem Titanoxid oder dem Zinnoxid für die erste Antireflexschicht (10) zwischen 0,2 und 0,5 liegt.

5.  Lichtdurchlässiger Träger (01) nach einem der vorangehenden Ansprüche,
    **dadurch gekennzeichnet, dass**
    die Temperaturstabilität dauerhaft bis zu einer Temperatur von 650°C und kurzzeitig bis zu einer Temperatur von 950°C gewährleistet ist.

6.  Lichtdurchlässiger Träger (01) nach einem der vorangehenden Ansprüche,
    **dadurch gekennzeichnet, dass**
    eine zweite Antireflexschicht (11) vorgesehen ist, die an die erste Antireflexschicht (10) anschließt und weiterer Bestandteil der Lichteinfangstruktur (02) ist, wobei die zweite Antireflexschicht (11) einen Brechungsindex aufweist, der größer ist als der effektive Brechungsindex der gesamten Lichteinfangstruktur (02).

7.  Lichtdurchlässiger Träger (01) nach Anspruch 6,
    **dadurch gekennzeichnet, dass**

die zweite Antireflexschicht (11) aus Siliziumnitrid besteht.

8. Lichtdurchlässiger Träger (01) nach einem der vorangehenden Ansprüche,
**dadurch gekennzeichnet, dass**
die Passivierungsschicht (12) aus Siliziumoxid oder Siliziumoxinitrid oder Aluminiumoxid besteht.

9. Lichtdurchlässiger Träger (01) nach einem der vorangehenden Ansprüche,
**dadurch gekennzeichnet, dass**
das Superstrat (03) aus Glas besteht.

10. Lichtdurchlässiger Träger (01) nach einem der vorangehenden Ansprüche,
**dadurch gekennzeichnet, dass**
das Superstrat (03) großflächig ausgebildet ist.

11. Verfahren zur Herstellung eines lichtdurchlässigen Trägers (01) nach einem der Ansprüche 1 bis 10 für einen halbleitenden Dünnschichtaufbau (14) mit einem Superstrat (03) mit einer für Lichteinfall (04) vorgesehenen Oberseite (05) und einer Unterseite (06), auf der eine die optischen Eigenschaften des Superstrats (03) verbessernden Lichteinfangstruktur (02) angeordnet ist, an die der Dünnschichtaufbau (14) anschließbar ist, wobei die Lichteinfangstruktur (02) zumindest aus einer dreidimensionalen Strukturschicht (09) im Submikrometerbereich aus Siliziumoxid auf dem Superstrat (03) besteht, nach einem der vorangehenden Ansprüche,
mindestens aufweisend die Verfahrensschritte:

- Bereitstellen eines lichtdurchlässigen Superstrats (03),
- Aufbringen einer siliziumbasierten Sol-Gel-Schicht auf die Unterseite (06) des Superstrats (03),
- Einstempeln einer periodischen Nanostruktur (07) in die Sol-Gel-Schicht mittels Nanoimprint-Lithographie,
- thermische Behandlung der strukturierten Sol-Gel-Schicht zur Ausbildung einer strukturierten Siliziumoxidschicht als Strukturschicht (09) auf dem Superstrat (03),

**gekennzeichnet, durch die folgenden Verfahrensschritte:**

- Aufbringen einer Titanoxid- oder Zinnoxid-Vorläuferlösung auf die Strukturschicht (09) mittels Schleuderbeschichtung,
- thermische Behandlung der aufgeschleuderten Titanoxid- oder Zinnoxid-Vorläuferlösung zur Ausbildung einer nanokristallinen Titanoxidschicht oder Zinnoxidschicht als eine erste Antireflexschicht (10) und
- Aufbringen von Siliziumoxid oder Siliziumoxinitrid auf die ausgebildete erste Antireflexschicht (10) durch physikalische oder chemische Gasphasenabscheidung zur Ausbildung einer Passivierungsschicht (12) auf der ersten Antireflexschicht (10),

wobei alle verwendeten Komponenten eine Temperaturstabilität dauerhaft bis 650°C und kurzzeitig bis 950°C aufweisen.

12. Verfahren nach Anspruch 11,
**gekennzeichnet durch** den zusätzlichen Verfahrensschritt:

* Aufbringen einer zweiten Antireflexschicht (11) im Anschluss an das Aufbringen der ersten Antireflexschicht (10), wobei die zweite Antireflexschicht (11) einen Brechungsindex aufweist, der größer ist als der effektive Brechungsindex der gesamten Lichteinfangstruktur (02), und wobei die Passivierungsschicht (12) dann auf die zweite Antireflexschicht (11) aufgebracht wird.

13. Verfahren nach Anspruch 12,
**gekennzeichnet durch**
Aufbringen von Siliziumnitrid als zweite Antireflexschicht (11).

14. Verwendung eines lichtdurchlässigen Trägers (01) nach einem der Ansprüche 1 bis 10 in einem Prozess zur Erzeugung eines halbleitenden Dünnschichtaufbaus (14) zur Verwendung in einer Solarzelle, wobei der halbleitende Dünnschichtaufbau (14) durch Flüssigphasen-Laserkristallisation erzeugt wird.

Claims

1. Transparent support (01) for a semi-conducting thin layer structure (14) with a superstrate (03) with an upper side (05) intended for incidence of light (04) and an underside (06) on which is arranged a light trapping structure (02) which improves the optical properties of the superstrate (03) and to which the thin layer structure (14) is connectable, wherein the light trapping structure (02) comprises at least one three-dimensional structural layer (09) in the sub-micrometre range made of silicon oxide on the superstrate (03),
**characterised in that**
the three-dimensional structural layer (09) is designed with a periodic nanostructure (07) with a period P between 200 nm and 1000 mm and a first anti-reflection layer (10) following the structural layer (09) designed as a nanocrystalline titanium oxide layer or as a tin oxide layer, wherein the first anti-reflection layer (10) reduces the relative height HN of the nanostructure (07) of the structure layer (09) by at least 30% so that the residual height HL of the light trapping structure (02) is levelled and wherein the height HL of the light trapping structure (02) is between 20 nm and 200 nm and the angles W between the surfaces (13) of the light trapping structure (02) and the underside (06) of the superstrate (03) are no greater than 60°, and **in that** a passivisation layer (12) is arranged on the light trapping structure (02), ensuring temperature stability of the support (01) for liquid phase crystallisation.

2. Transparent support (01) according to claim 1,
**characterised in that**
the periodic nanostructure (07) is designed in the form of nanocylinders (08) which are spaced with regard to each other and **in that** a filling ratio between the silicon oxide for the structure layer (09) and the titanium oxide or tin oxide for the first anti-reflection layer (10) is a function of diameter D, period P and arrangement of the nanocylinders (08) and is inbetween 0.2 and 0.5.

3. Transparent support (01) according to claim 2,
**characterised in that**
the period P of the periodic nanostructure (07) is 750 nm in the case of a hexagonal arrangement of the nanocylinders (08), the HL of the light trapping structure (02) is 60 mm and the filling ratio is 0.25.

4. Transparent support (01) according to claim 1,
**characterised in that**
the periodic nanostructure (07) is of a non-cylindrical shape and the filling ratio between the silicon oxide for the structural layer (09) and the titanium oxide or tin oxide for the first anti-reflection layer (10), resulting as the quotient of the equivalence diameter of the non-cylindrical shapes to the period P of the non-cylindrical shapes, is between 0.2 and 0.5.

5. Transparent support (01) according to any one of the preceding claims
**characterised in that**
the temperature stability is permanently guaranteed up to a temperature of 650°C and temporary up to a temperature of 950°C.

6. Transparent support (01) according to any one of the preceding claims
**characterised in that**
a second anti-reflection layer (11) is provided which adjoins the first anti-reflection layer (10) and constitutes a further component part of the light trapping structure (02), wherein the second anti-reflection layer (11) has a refractive index which is greater than the effective refractive index of the entire light trapping structure (02).

7. Transparent support (01) according to claim 6,
**characterised in that**
the second anti-reflection layer (11) is made of silicon nitride.

8. Transparent support (01) according to any one of the preceding claims
**characterised in that**
the passivisation layer (12) is made of silicon oxide or silicon oxynitride or aluminium oxide.

9. Transparent support (01) according to any one of the preceding claims
**characterised in that**
the superstrate (03) is made of glass.

**10.** Transparent support (01) according to any one of the preceding claims
**characterised in that**
the superstrate (03) is of a large-scale configuration.

**11.** Method of producing a transparent support (01) according to any one of claims 1 to 10 for a semi-conducting thin layer structure (14) with a superstrate (03) with an upper side (05) intended for incidence of light (04) and an underside (06) on which is arranged a light trapping structure (02) which improves the optical properties of the superstrate (03) and to which the thin layer structure (14) is connectable, wherein the light trapping structure (02) comprises at least one three-dimensional structural layer (09) in the sub-micrometre range made of silicon oxide on the superstrate (03), according to any one of the preceding claims,
comprising at least the procedural steps:

• provision of a transparent superstrate (03),
• application of a silicon-based sol-gel layer to the underside (06) of the superstrate (03),
• stamping of a periodic nanostructure (07) into the sol-gel layer by means of nanoimprint lithography,
• thermal treatment of the structured sol-gel layer to form a structured silicon oxide layer as the structural layer (09) on the superstrate (03),

**characterised by the following procedural steps:**

• application of a titanium oxide or tin oxide precursor solution to the structural layer (09) by means of spin coating,
• thermal treatment of the spun-on titanium oxide or tin oxide precursor solution to form a nanocrystalline titanium oxide or tin oxide layer as a first anti-reflection layer (10) and
• application of silicon oxide or silicon oxynitride to the formed first anti-reflection layer (10) through physical or chemical vapour deposition to create a passivisation layer (12) on the first anti-reflection layer (10), wherein all the used components exhibit a temperature stability permanently up to 650°C and temporary up to 950°C.

**12.** Method according to claim 11,
**characterised by** the additional procedural step:

• application of a second anti-reflection layer (11) subsequent to the application of the first anti-reflection layer (10), wherein the second anti-reflection layer (11) has a refractive index which is greater than the effective refractive index of the entire light trapping structure (02), and wherein the passivisation layer (12) is then applied to the second anti-reflection layer (11).

**13.** Method according to claim 12,
**characterised by**
the application of silicon nitride as the second anti-reflection layer (11).

**14.** Use of a transparent support (01) according to any of claims 1 to 10 in a process for producing a semiconducting thin layer structure (14) for use in a solar cell, wherein the semiconducting thin layer structure (14) is produced through liquid phase laser crystallisation.

**Revendications**

**1.** Support transparent (01) pour un montage semiconducteur de couches minces (14), pourvu d'un substrat supérieur (03) doté d'une face supérieure (05) prévue pour l'incidence lumineuse (04) et d'une face inférieure (06), sur laquelle est placée une structure de capture de la lumière (02) qui améliore les propriétés optiques du substrat supérieur (03) sur laquelle le montage de couches minces (14) est susceptible de se raccorder, la structure de capture de la lumière (02) étant constituée d'au moins une couche structurelle (09) tridimensionnelle de l'ordre du submicromètre en oxyde de silicium sur le substrat supérieur (03),
**caractérisé en ce que**
la couche structurelle (09) tridimensionnelle avec une nanostructure (07) périodique présentant une période P comprise entre 200 nm et 1000 nm et une première couche antireflet (10) consécutive à la couche structurelle (09) sont conçues en tant que couche d'oxyde de titane nanocristalline ou en tant que couche d'oxyde d'étain, la première couche antireflet (10) réduisant d'au moins 30 % la hauteur HN de la nanostructure (07) de la couche structurelle (09), de sorte que la hauteur résiduelle HR de la structure de capture de la lumière (02) est lissée, et la hauteur HL de la structure de capture de la lumière (02) étant comprise entre 20 nm et 200 nm et les angles W entre les surfaces (13) de la structure de capture de la lumière (02) et la face inférieure (06) du substrat supérieur (03) n'étant pas supérieurs à 60°, et **en ce que** sur la structure de capture de la lumière (02) est placée une couche de passivation (12), une stabilité thermique du support (01) pour une cristallisation en phase liquide étant donnée.

2. Support transparent (01) selon la revendication 1,
**caractérisé en ce que**
la nanostructure (07) périodique est conçue sous la forme de nanocylindres (08) mutuellement écartés et **en ce que** le rapport de remplissage résultant en fonction du diamètre D, de la période P et du placement des nanocylindres (08) entre l'oxyde de silicium pour la couche structurelle (09) et l'oxyde de titane ou l'oxyde d'étain pour la première couche antireflet (10) se situe entre 0,2 et 0,5.

3. Support transparent (01) selon la revendication 2,
**caractérisé en ce que**
dans le cas d'un placement hexagonal des nanocylindres (08), la période P de la nanostructure (07) périodique s'élève à 750 nm, la hauteur HL de la structure de capture de la lumière (02) s'élève à 60 nm et le rapport de remplissage s'élève à 0,25.

4. Support transparent (01) selon la revendication 1,
**caractérisé en ce que**
la nanostructure (07) périodique présente une expression non cylindrique et le rapport de remplissage résultant en tant que quotient d'un diamètre équivalent des expressions non cylindriques à la période P des expressions non cylindriques entre l'oxyde de silicium pour la couche structurelle (09) et l'oxyde de titane ou l'oxyde d'étain pour la première couche antireflet (10) se situe entre 0,2 et 0,5.

5. Support transparent (01) selon l'une quelconque des revendications précédentes,
**caractérisé en ce que**
la stabilité thermique est assurée durablement jusqu'à une température de 650°C et à court terme jusqu'à une température de 950°C.

6. Support transparent (01) selon l'une quelconque des revendications précédentes,
**caractérisé en ce que**
une deuxième couche antireflet (11) est connectée à la première couche antireflet (10) et qui est un élément constitutif supplémentaire de la structure de capture de la lumière (02), la deuxième couche antireflet (11) présentant un indice de réfraction qui est supérieur à l'indice de réfraction effectif de l'ensemble de la structure de capture de la lumière (02).

7. Support transparent (01) selon la revendication 6,
**caractérisé en ce que**
la deuxième couche antireflet (11) est constituée de nitrure de silicium.

8. Support transparent (01) selon l'une quelconque des revendications précédentes,
**caractérisé en ce que**
la couche de passivation (12) est constituée d'oxyde de silicium ou d'oxynitrure de silicium ou d'oxyde d'aluminium.

9. Support transparent (01) selon l'une quelconque des revendications précédentes,
**caractérisé en ce que**
le substrat supérieur (03) est constitué de verre.

10. Support transparent (01) selon l'une quelconque des revendications précédentes,
**caractérisé en ce que**
le substrat supérieur (03) est constitué à grande surface.

11. Procédé, destiné à fabriquer un support (01) transparent selon l'une quelconque des revendications 1 à 10, destiné à un montage semiconducteur de couches minces (14), pourvu d'un substrat supérieur (03) doté d'une face supérieure (05) prévue pour l'incidence lumineuse (04) et d'une face inférieure (06), sur laquelle est placée une structure de capture de la lumière (02) qui améliore les propriétés optiques du substrat supérieur (03) sur laquelle le montage de couches minces (14) est susceptible de se raccorder, la structure de capture de la lumière (02) étant constituée d'au moins une couche structurelle (09) tridimensionnelle de l'ordre du submicromètre en oxyde de silicium sur le substrat supérieur (03) selon l'une quelconque des revendications précédentes, comportant au moins les étapes de procédé consistant à :

- mettre à disposition un substrat supérieur (03) transparent,
- appliquer une couche sol-gel à base de silicium sur la face inférieure (06) du substrat supérieur (03),
- poinçonner une nanostructure (07) périodique dans la couche sol-gel, au moyen d'une lithographie par nano-impression,
- traiter thermiquement la couche sol-gel structurée pour créer une couche d"oxyde de silicium structurée en tant que couche structurelle (09) sur le substrat supérieur (03),

**caractérisé par les étapes de procédé suivantes, consistant à :**

- appliquer une solution de précurseur d'oxyde de titane ou d'oxyde d'étain sur la couche structurelle (09), par revêtement par centrifugation,
- traiter thermiquement la solution de précurseur d'oxyde de titane ou d'oxyde d'étain appliquée par centrifugation, pour créer une couche d'oxyde de titane ou couche d'oxyde d'étain nanocristalline en tant qu'une première couche antireflet (10) et
- appliquer de l'oxyde de silicium ou de l'oxynitrure de silicium sur la première couche antireflet (10) créée, par dépôt physique ou chimique en phase gazeuse, pour créer une couche de passivation (12) sur la première couche antireflet (10),

tous les composants utilisés faisant preuve d'une stabilité thermique durable jusqu'à 650°C et à court terme jusqu'à 950°C.

12. Procédé selon la revendication 11,
**caractérisé par** l'étape de procédé supplémentaire, consistant à :

- appliquer une deuxième couche antireflet (11) à la suite de l'application de la première couche antireflet (10), la deuxième couche antireflet (11) faisant preuve d'un indice de réfraction qui est supérieur à l'indice de réfraction effectif de l'ensemble de la structure de capture de la lumière (02), et la couche de passivation (12) étant appliquée ensuite sur la deuxième couche antireflet (11).

13. Procédé selon la revendication 12,
**caractérisé par**
l'application de nitrure de silicium en tant que deuxième couche antireflet (11).

14. Utilisation d'un support (01) transparent selon l'une quelconque des revendications 1 à 10 lors d'un processus de production d'un montage semiconducteur de couches minces (14), destiné à être utilisé dans une cellule photovoltaïque, le montage semiconducteur de couches minces (14) étant produit par cristallisation en phase liquide au laser.

Fig.1

**Fig.2**

EP 3 449 509 B1

Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050030629 A1
- US 20110151222 A1
- US 20120018733 A1
- US 20110132442 A1
- DE 102009006719 A1

**In der Beschreibung aufgeführte Nicht-Patentliteratur**

- **K. SÖDERSTRÖM et al.** Experimental study of flat light-scattering substrates in thin-film silicon solar cells. *Solar Energy Materials & Solar Cells,* 2012, vol. 101, 193-199
- **Y. D. KIM et al.** Novel patterned layer to enhance conversion efficiency of amorphous silicon thin-film solar cells. *Phys. Stat. Solidi A,* 2014, vol. 211, 1493-1498
- **D. ARMKREUTZ et al.** Liquid-Phase Crystallized Silicon Solar Cells on Glass: Increasing the Open-Circuit Voltage by Optimized Interlayers for n- and p-Type Absorbers. *IEEE Journal of Photovoltaics,* November 2015, vol. 5 (6), 1757-1761
- **F. BACK et al.** Periodic nanostructures imprinted on high-temperature stable sol-gel films. *Thin Solid Films,* 2014, vol. 563, 274-281
- **JONATHAN PLENTZ ; TU ILMENAU.** *Laserkristallisierte multikristalline Silicium-Dünnschicht-Solarzellen auf Glas,* 08. Mai 2013, http://www.gbv.de/dms/ilmenau/toc/745828043.PDF